# EUROPÄISCHE PATENTANMELDUNG

(11) **EP 2 993 782 A1**
(43) Veröffentlichungstag der Anmeldung: **09.03.2016**
(21) Anmeldenummer: 14183858.1
(22) Anmeldetag: 05.09.2014
(51) Int. Cl.: H02S 30/20

(54) **Solarkollektor**

(71) Anmelder: Novosol GmbH & Co. KG, 44227 Dortmund (DE)
(72) Erfinder: Tourel, Sylvain, 45525 Hattingen (DE)
(74) Vertreter: Simandi, Claus

(57) **Zusammenfassung**

Die vorliegende Erfindung betrifft einen Solarkollektor, also ein Gerät mit dem Sonnenlicht in einer andere Energieform umgewandelt werden kann, vorzugweise elektrische Energie. Insbesondere geht es um einen Solarkollektor (20), der eine Vielzahl von Solarpaneelen (10, 12, 14, 16) umfasst, welche sich im Wesentlichen in einer Paneelfläche erstrecken, wobei jedes Solarpaneel mindestens eine Solarzelle umfasst, wobei der Solarkollektor mindestens einen Paneelverband (18) umfasst, welcher mindestens ein erstes Solarpaneel (10) und mindestens ein zweites Solarpaneel (12) umfasst, wobei das erste Solarpaneel (10) eine erste Flächensenkrechte (S₁) auf der Paneelfläche (E₁) aufweist, und wobei das zweite Solarpaneel (12) eine zweite Flächensenkrechte (S₂) auf der Paneelfläche (E₂) aufweist, und wobei das erste Solarpaneel (10) und das zweite Solarpaneel (12) nicht in einer Ebene verlaufen, und der Paneelverband eine Hauptachse (H) aufweist, welche im Wesentlichen parallel zur Paneelfläche des ersten Solarpaneels (10) und zur Paneelfläche des zweiten Solarpaneels (12) verläuft, und welche den Kreuzungspunkt der ersten Flächensenkrechten (S₁) mit der zweiten Flächensenkrechten (S₂) schneidet, dadurch gekennzeichnet, dass die Hauptachse (H) kein Solarpaneel des Paneelverbandes schneidet, und Solarpaneele in einem Winkelbereich von mindestens 180 Grad um die Hauptachse (H) angeordnet sind.

## Beschreibung

### Gebiet der Erfindung

Die vorliegende Erfindung betrifft einen Solarkollektor, also ein Gerät mit dem Sonnenlicht in einer andere Energieform umgewandelt werden kann, vorzugweise elektrische Energie. Dabei können Solarzellen auf Halbleiterbasis zum Einsatz kommen.

### Hintergrund der Erfindung

Die US- Patentanmeldung US 2010/0252085 A1 betrifft einen Solarkollektor, bei der eine Parabolschüssel dazu verwendet wird, Licht auf eine im Brennpunkt der Schüssel angeordnete Solarzelle zu fokussieren. Die Parabolschüssel steht auf einem Stativ, so dass die Schüssel dem Sonnenstand entsprechend gedreht werden kann. Dazu ist eine aufwändige mechanische Verstelleinrichtung erforderlich.

Die US-Patentanmeldung US 2011/0272368 A1 ist repräsentativ für einen anderen bekannten Ansatz, bei dem ein Ständer zur Verfügung gestellt wird, auf dem Solarpaneele in einer langen Schrägfläche angeordnet werden können.

Die deutsche Offenlegungsschrift DE 199 22 795 A1 betrifft eine Weiterentwicklung dieses Konzeptes. Wiederum sind Solarmodule zu einer ausgedehnten Schrägfläche angeordnet. Bei dem in dieser Offenlegungsschrift vorgestellten Ständer kann man die Neigung dieser schrägen Fläche jedoch einstellen.

Die deutsche Gebrauchsmusterschrift DE 20 2006 003 476 U1 betrifft einen noch weitergehenden Ansatz. In diesem Fall kann nicht nur der Neigungswinkel der Schrägfläche variiert werden, sondern zusätzlich können die Solarmodule innerhalb der Schrägfläche verkippt werden. Für das alles sind hydraulische Antriebe vorgesehen.

Das europäische Patent EP 3 47 443 B1 offenbart ein Solarmodul, bei welchem rinnenförmige Spiegel verwendet werden. Diese Spiegel werden mit Sandwich-Solarzellen kombiniert, welche auf ihrer Oberseite und auf ihrer Unterseite Licht einfangen können. Auf der Oberseite geschieht das direkt, auf der Unterseite erst nach Reflektion durch die rinnenförmigen Spiegel. Dazu soll die Breite der Solarmodule dem Durchmesser des Halbkreises entsprechen, welchen die Rinne im Querschnitt hat.

Das europäische Patent EP 4 64 738 B1 gibt ein Beispiel für die Nutzung von Solarmodulen auf Schiffen. Dabei sollen mehrere Solarzellen zu einem rahmenlosen Solarzellenlaminat verbunden werden. Diese können auch auf einer begehbaren Deckfläche positioniert werden.

Die US-Patentanmeldung US 2011/0146752 A1 zeigt eine Solarzellenanordnung, bei der ebenfalls eine mechanische Verstellung der Paneele mit den Solarzellen vorgesehen ist. Zur Kühlung soll ein Flüssigkeitskreislauf dienen, in der Regel soll Wasser durch Kupferrohre fließen, um Hitze von den Solarzellen abzuleiten. Zusätzlich ist ein Reinigungssystem vorgesehen, über das Wasser an Sprühauslässe geleitet werden kann. Dadurch sollen dann die Solarflächen gereinigt werden. Die Möglichkeit zu Kühlen und zu Reinigen erfordert hier einen komplizierten Aufbau.

Die vorliegene Erfindung will diesen Stand der Technik verbessern. Insbesondere soll ein Solarkollektor angeboten werden, der bei geringem mechanischem Aufwand und damit bei hoher Zuverlässigkeit eine gute Energieausbeute bringt. Er soll an verschieden Orten, insbesondere auch auf Schiffen einsetzbar sein.

### Beschreibung der Erfindung

Diese Aufgabe wird durch einen Solarkollektor nach Anspruch 1 gelöst.

Der Solarkollektor kann eine Vielzahl von Solarpaneelen umfassen. Er wird mindestens zwei Paneele umfassen, kann aber auch mehrere hundert Solarpaneele umfassen.

Bei den Solarpaneelen handelt es sich um Einheiten, welche Sonnenlicht in eine andere Energieform umwandeln können. Dies kann auf verschiedene Weise geschehen, beispielsweise durch Erwärmung eines Mediums. Die Solarpaneele sollen Solarzellen aufweisen. Typischerweise verwandeln Solarzellen Sonnenlicht in Strom. Dazu werden in bekannter Weise Halbleiter in sogenannten Wafern eingesetzt. Unter einer Solarzelle soll hier jedoch jede Zelle verstanden werden, welche Sonnenlicht in eine andere Energieform umwandelt.

Jedes Solarpaneel kann eine oder mehrere Solarzellen umfassen. Mehrere Solarzellen können in der Haupterstreckungsebene des Paneels nebeneinander angeordnet werden.

Der Solarkollektor umfasst mindestens einen Paneelverband. Er kann auch sehr viel mehr Paneelverbände umfassen, beispielsweise mehrere Dutzend Paneelverbände. Ein Paneelverband umfasst mindestens zwei Solarpaneele, nämlich ein erstes Solarpaneel und ein zweites Solarpaneel. Das erste und das zweite Solarpaneel des Paneelverbandes verlaufen nicht in einer Ebene. Das erste Solarpaneel weist eine Flächensenkrechte auf und das zweite Solarpaneel weist eine Flächensenkrechte auf. Diese schneiden sich in einem bestimmten Punkt, da das erste Solarpaneel und das zweite Solarpaneel nicht in einer Ebene verlaufen. Die senkrechten werden zweckmäßigerweise jeweils über dem Flächenschwerpunkt der jeweiligen Paneele errichtet.

Der Paneelverband weist eine Hauptachse auf, welche im Wesentlichen parallel zur Paneelfläche des ersten Solarpaneels und zur Paneelfläche des zweiten Solarpaneels verläuft. Diese Hauptachse verläuft auch durch den beschriebenen Kreuzungspunkt der ersten Flächensenkrechten mit der zweiten Flächensenkrechten. Die Hauptachse ist eine der Hauptträgheitsachsen des Paneelverbandes (und soll dies allgemein vorzugsweise sein).

Der Solarkollektor soll so konstruiert werden, dass diese Hauptachse höchstens ein Solarpaneel des Paneelverbandes schneidet. Häufig ist es zweckmäßig, den Paneelverband so zu gestalten, dass die Hauptachse gar kein Solarpaneel des Paneelverbandes schneidet.

Ferner sollen Solarpaneele in einem Winkelbereich von mindestens 180 Grad um die Hauptachse herum angeordnet werden. Diese geometrische Anordnung des Solarkollektors erlaubt eine wesentlich höhere Lichtausbeute als bisher üblich. Dies gilt insbesondere für solche Fälle, bei der der Solarkollektor nicht bewegt wird. Weil die Hauptachse maximal ein Solarpaneel des Paneelverbandes schneidet, bietet der Paneelverband mindestens eine offene Fläche an, in die Sonnenlicht einfallen kann. Dabei ist ein steiler Einfall des Sonnenlichtes möglich, etwa parallel zur Hauptachse, typisch und zweckmäßig ist meist ein Einfall des Sonnenlichtes in einem Winkel von 10 bis 80, meist auch 30 bis 60 Grad zur Hauptachse. Während sich der Stand der Sonne im Tagesverlauf ändert, werden verschiedene Bereiche des Solarpaneels stärker beschienen. Da das Sonnenlicht in der Regel aber in einem Winkel zur Hauptachse einfällt, wandert der am stärksten beschienene Bereich auf einem Kreis rund um die Hauptachse. Weil auf einem solchen Kreis um die Hauptachse in einem Winkelbereich von mindestens 180 Grad Solarpaneele angeordnet sind, ist es aber bei verschiedenen Sonnenständen möglich, den Solarkollektor effektiv zu nutzen.

Besonders effektiv ist die Nutzung des Solarkollektors, wenn in einem Winkelbereich von mehr als 270 Grad um die Hauptachse herum Solarpaneele angeordnet sind. Es ist auch möglich und kann zweckmäßig sein, in einem Winkelbereich von 360 Grad um die Hauptachse herum Solarpaneele anzuordnen. Zusätzlich zu den Solarpaneelen, welche in einem solchen Winkelbereich angeordnet sind, kann es zweckmäßig sein, ein zusätzliches Solarpaneel vorzusehen, welches die Hauptachse schneidet. Dieses kann als Boden eines nach oben offenen Kastens verstanden werden, dessen übrige Wände durch die übrigen Solarpaneele gebildet werden, und in dessen offene "Deckel"-Seite Sonnenlicht hineinscheinen kann.

Es ist zweckmäßig, einen Paneelverband aus drei bis fünf Solarpaneelen zur Verfügung zu stellen. Ein Paneelverband aus drei Solarpaneelen kann in einem Querschnitt senkrecht zur Hauptachse eine Dreiecksform haben. Ein Paneelverband aus vier Paneelen kann in einer solchen Querschnittsansicht eine Rechtecksform, Rautenform oder eine quadratische Form haben. Die Verwendung von vier Paneelen hat sich als besonders zweckmäßig erwiesen.

Die Solarpaneele selbst können auch in der Paneelebene eine rechteckige Form haben. Sie können auch die typische runde Waver-Form haben.

Ein besonders zweckmäßiger Solarkollektor ergibt sich, wenn der Winkel zwischen dem ersten Solarpaneel und dem angrenzenden zweiten Solarpaneel veränderlich ist. Zum einen kann dann die Stellung der Solarpaneele auf den Sonneneinfall hin optimiert werden. Zum anderen kann der Paneelverband von einer Nutzstellung in eine Transportstellung überführt werden.

Zweckmäßig ist es auch, in einem Solarkollektor Paneele so anzuordnen, dass ihre Paneelflächen parallel zueinander sind, und die Solarzellen entgegengesetzt orientiert. Solche Solarpaneelpaare, die gewissermaßen Rücken an Rücken angeordnet sind, können Teile benachbarter Paneelverbände sein. In dieser Weise lässt sich ein größerer Solarkollektor sehr kompakt bauen.

Zweckmäßig ist es auch, einen Solarkollektor mit einer Vielzahl von Paneelverbänden zur Verfügung zu stellen, bei dem die Paneelverbände parallel ausgerichtete Hauptachsen aufweisen.

Die Paneelverbände können sich in einer Ebene E_{A}, welche senkrecht zu den Hauptachsen H verläuft, über eine erste Fläche erstrecken. Zweckmäßig ist es, wenn diese Fläche in ihrer Größe veränderlich ist.

Zweckmäßig ist es, einen Solarkollektor zur Verfügung zu stellen, welcher durch einen ersten Halter und durch einen zweiten Halter gehalten werden kann. Dabei ist es besonders zweckmäßig, wenn diese Halter in der Ebene E_{A} bewegt werden können, vorzugsweise können sie in der Ebene entlang einer ersten Richtung aufeinander zu und voneinander wegbewegt werden.

Besonders zweckmäßig ist der erfindungsgemäße Solarkollektor, insbesondere wenn er beweglich gebaut wird, insbesondere zur Verwendung auf einem Schiff. Dabei kann die Ebene E_{A} sowohl waagerecht als auch senkrecht ausgerichtet sein.

Die Erfindung bezieht sich daher auch auf ein Schiff, vorzugsweise Segelschiff, welches einen Solarkollektor der beschriebenen Art aufweist.

Weitere Merkmale, aber auch Vorteile der Erfindung, ergeben sich aus den nachfolgend aufgeführten Zeichnungen und der zugehörigen Beschreibung. In den Abbildungen und in den dazugehörigen Beschreibungen sind Merkmale der Erfindung in Kombination beschrieben. Diese Merkmale können allerdings auch in anderen Kombinationen von einem erfindungsgemäßen Gegenstand umfasst werden. Jedes offenbarte Merkmal ist also auch als in technisch sinnvollen Kombinationen mit anderen Merkmalen offenbart zu betrachten. Die Abbildungen sind teilweise leicht vereinfacht und schematisch.
- Fig. 1: zeigt in schematischer Ansicht die Anordnung von Solarpaneelen in einem Paneelverband.
- Fig. 2: zeigt in schematischer Ansicht die Anordnung von Paneelverbänden in einem größeren Solarkollektor.
- Fig. 3: zeigt in schematischer Aufsicht eine Ausführungsform eines Solarkollektors.
- Fig. 4: zeigt in schematischer Aufsicht eine andere Ausführungsform eines Solarkollektors.
- Fig. 5A: zeigt in schematischer Ansicht eine Aufsicht auf eine Ausführungsform eines verstellbaren Solarkollektors, der eine große Fläche bedeckt.
- Fig. 5B: zeigt in schematischer Ansicht eine entsprechende Ansicht, in der der verstellbare Solarkollektor eine kleinere Fläche bedeckt.
- Fig. 5C: zeigt in entsprechender Ansicht die Bedeckung einer noch kleineren Fläche.
- Fig. 6A: zeigt in schematischer Ansicht die Anbringung eines erfindungsgemäßen Solarkollektors an einem Boot, wobei der Solarkollektor eine große Fläche abdeckt.
- Fig. 6B: zeigt in entsprechender Ansicht eine Stellung des Solarkollektors, in dem er eine kleine Fläche abdeckt.
- Fig. 7A: zeigt in schematischer Ansicht eine alternative Anbringung eines Solarkollektors an einem Boot, wobei der Solarkollektor eine große Fläche abdeckt.
- Fig. 7B: zeigt in entsprechender Ansicht eine Stellung, in der der Solarkollektor eine kleine Fläche abdeckt.

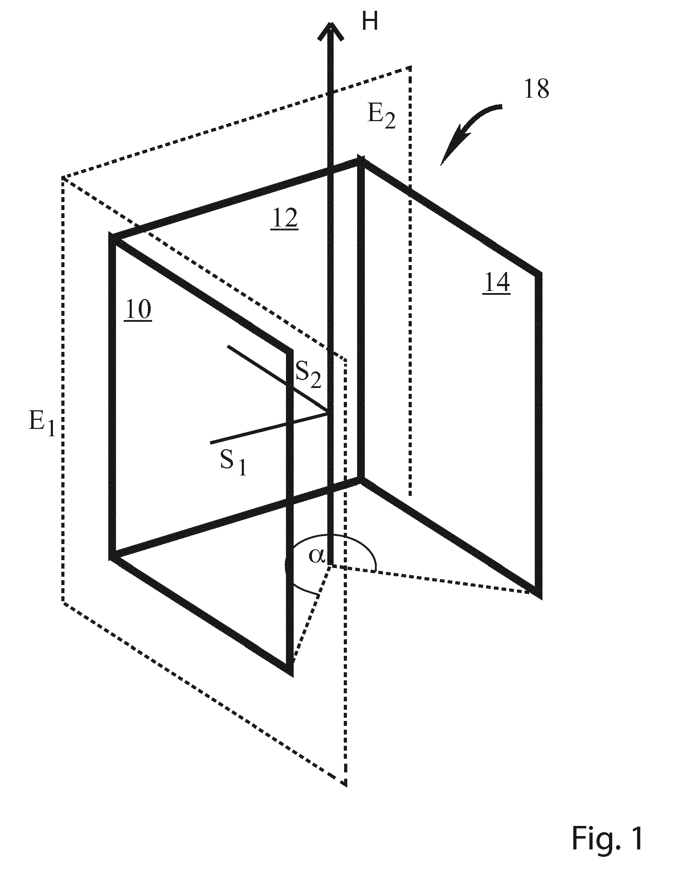

Fig. 1 zeigt in einer schematischen perspektivischen Ansicht einen Paneelverband, der Teil eines Solarkollektors sein kann. Erkennbar ist der Verlauf des ersten Solarpaneels 10, welches im Wesentlichen entlang einer Ebene, der Ebene E₁ verläuft. Rechtwinklig schließt sich das zweite Solarpaneel 12 an, welches in der Ebene E₂ verläuft. An dieses wiederum schließt sich das dritte Solarpaneel 14 an, welches seinerseits wiederum rechtwinklig auf dem zweiten Solarpaneel 12 steht. Die drei Solarpaneele legen also eine Würfelform fest und bilden drei Seitenflächen dieses Würfels. Gegenüber dem zweiten Solarpaneel 12 könnte ein viertes Solarpaneel (nachfolgend als Solarpaneel 16 dargestellt) vorgesehen sein, der dargestellte Paneelverband 18 besteht jedoch nur aus drei Solarpaneelen.

Das erste Solarpaneel 10 und das zweite Solarpaneel 12 legen den Verlauf der Hauptachse H fest, welche parallel zu beiden Erstreckungsebenen der Solarpaneele verläuft. Die Hauptachse H des Paneelverbandes schneidet zwei nach gleicher Art konstruierte Senkrechte auf der Ebene E₁ und auf der Ebene E₂. Die Senkrechte S₁ wurde auf dem Flächenschwerpunkt des ersten Solarpaneels 10 errichtet. Die Senkrechte S₂ wurde auf dem Flächenschwerpunkt des zweiten Solarpaneels 12 errichtet. Die Hauptachse H wird also durch Senkrechte auf den jeweiligen Flächenschwerpunkten festgelegt.

Die Hauptachse H verläuft durch die obere und durch die untere Fläche des Würfels. Beide Flächen sind frei von Paneelen. Dementsprechend kann Licht durch diese offenen Flächen einfallen. In einer Ebene senkrecht zur Hauptachse H trifft Licht auf die vorgesehenen Paneele. In dieser Ebene wird ein Winkelbereich α (Alpha) von 270 Grad durch Paneele bedeckt. Erfindungsgemäß soll der Paneelverband so gestaltet werden, dass dieser Winkel nicht weniger als 180 Grad beträgt.

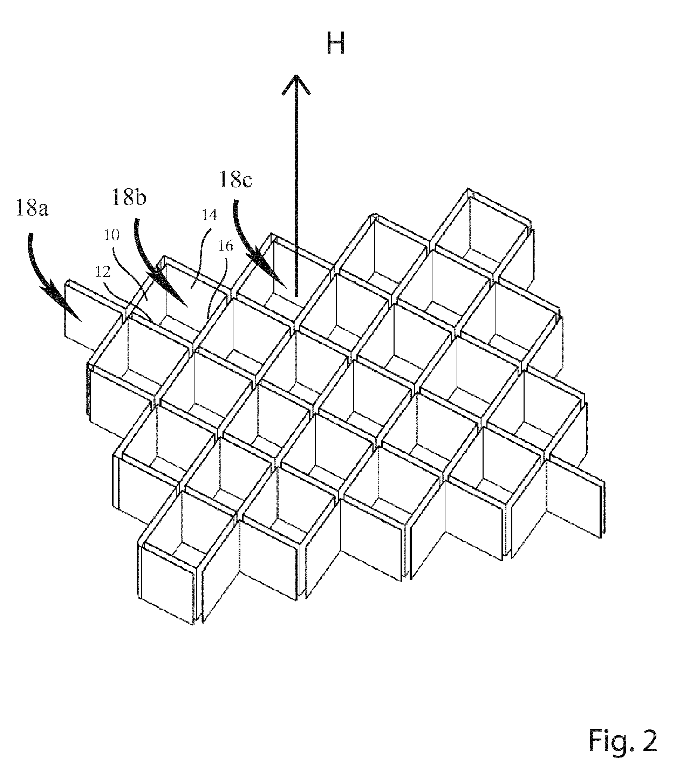

Fig. 2 zeigt in perspektivischer, schematisch leicht vereinfachter Darstellung einen Solarkollektor aus einer Vielzahl von Paneelverbänden. Gekennzeichnet sind die Paneelverbände 18a, 18b und 18c. Während der Paneelverband 18a nur aus zwei Solarpaneelen besteht und daher einen Winkelbereich α Alpha von nur etwa 180 Grad abgedeckt wird, bestehen die benachbarten Paneelverbände 18b und 18c jeweils aus vier Solarpaneelen, demgemäß wird bei den Paneelverbänden 18b und 18c ein Winkelbereich α (Alpha) von 360 Grad abgedeckt.

Für den Paneelverband 18b sind die entsprechenden Solarpaneele gekennzeichnet, dort sind ein erstes Solarpaneel 10, ein zweites Solarpaneel 12, ein drittes Solarpaneel 14 und ein viertes Solarpaneel 16 vorgesehen. Die vier Solarpaneele legen eine Würfelform fest. Sie bilden vier angrenzende Seiten dieses Würfels, die Decke und der Boden des Würfels bleiben offen. Dementsprechend kann aus diesen Richtungen Sonnenlicht gut einstrahlen.

Für den Paneelverband 18c ist die Richtung der Hauptachse eingezeichnet. Die anderen Paneelverbände verfügen über parallel verlaufende Hauptachsen.

Erkennbar ist auch, dass bei benachbarten Paneelverbänden die entsprechenden Solarpaneele Rücken an Rücken zueinander ausgerichtet sind, also sich parallel verlaufend berühren.

Der Solarkollektor kann leicht Sonnenlicht aus verschiedenen Richtungen aufnehmen. Optimal arbeitet er, wenn sich die Sonne auf einer Kegelfläche rund um die Achse H bewegt. Die Kegelfläche bildet zweckmäßigerweise einen Winkel von 10 bis 80, meist auch 30 bis 60 Grad zur Hauptachse.

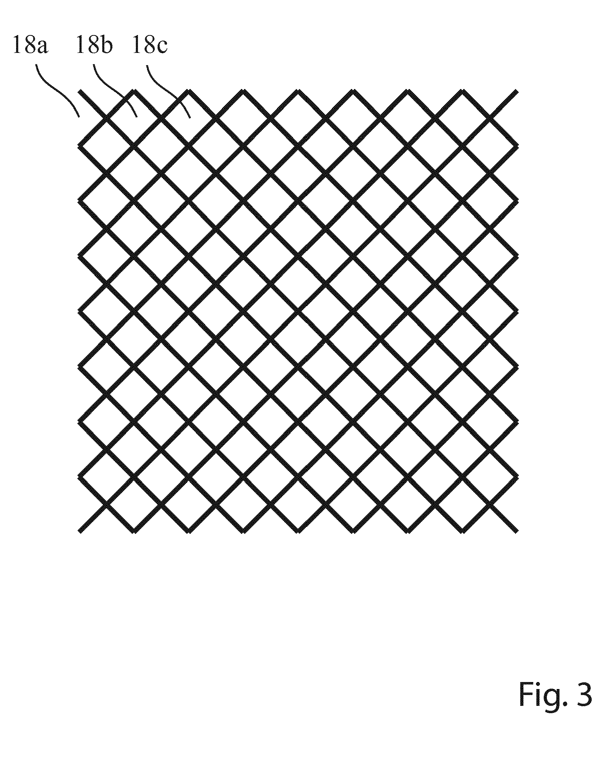

Fig. 3 zeigt in schematischer Ansicht die Aufsicht auf einen Solarkollektor, der im Wesentlichen der Konstruktion aus Fig. 2 entspricht jedoch eine etwas größere Anzahl von Paneelverbänden aufweist. Wiederum sind die Paneelverbände 18a, 18b und 18c gekennzeichnet. Man erkennt, dass es im Sinne der Erfindung nicht erforderlich ist, dass alle Paneelverbände die gleiche Anzahl von Solarpaneelen aufweisen. Dementsprechend müssen auch die Paneele aller Paneelverbände nicht einen gleichgroßen Winkelbereich α um die Hauptachse beschreiben.

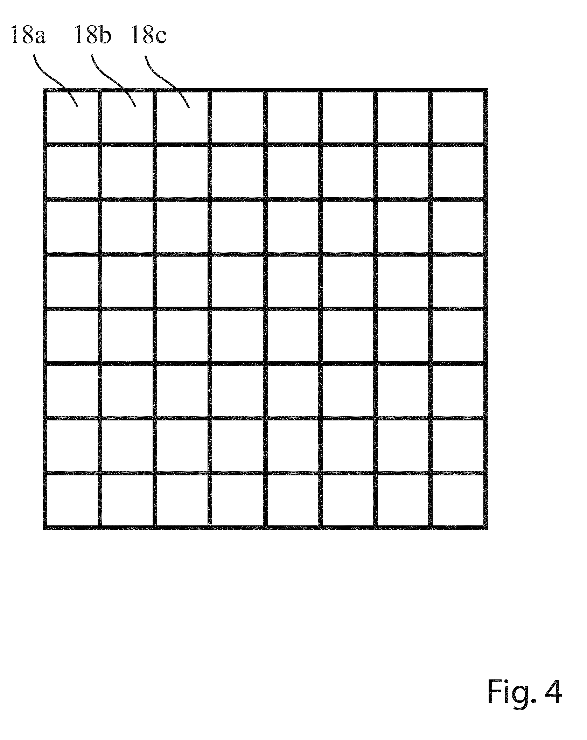

Fig. 4 zeigt in ebenfalls schematisch vereinfachter Ansicht eine alternative Ausführungsform eines erfindungsgemäßen Solarkollektors. Hierbei sind die Paneelverbände so angeordnet, dass alle Paneelverbände im Querschnitt ein Quadrat bilden. Auch am Rande des Solarkollektors sind Paneelverbände mit vier Solarpaneelen vorgesehen. Dementsprechend sind in einem Winkelbereich α (Alpha) von 360 Grad um die Hauptachse Solarpaneele vorgesehen.

Insbesondere wenn bei einem Paneelverband ein Winkelbereich von 360 Grad rund um die Hauptachse durch Paneele abgedeckt wird, so ist die Hauptachse als Symmetrieachse des Paneelverbandes zu wählen.

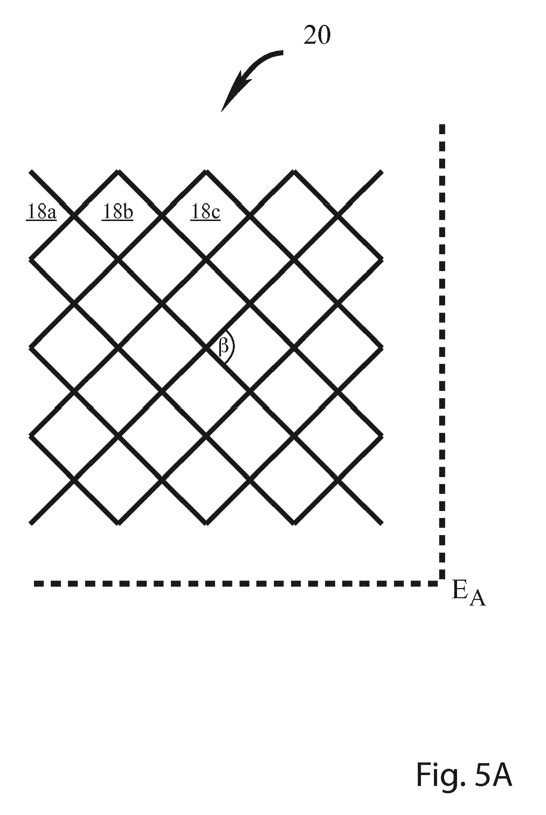

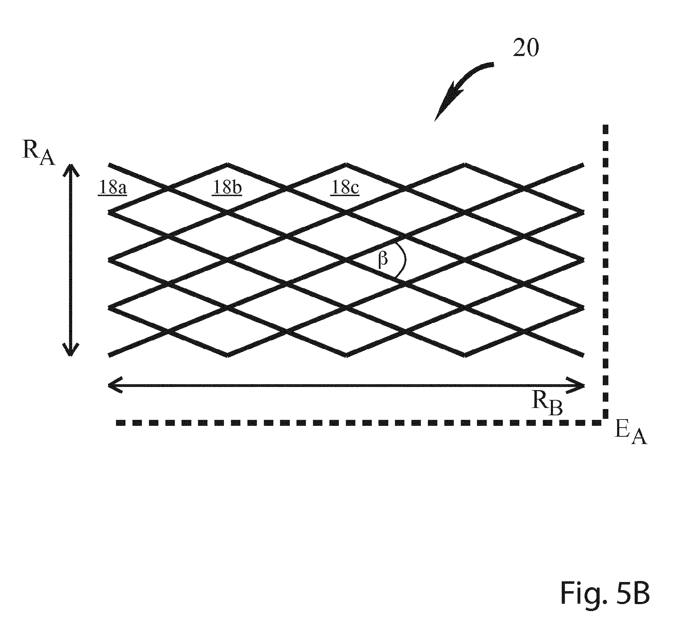

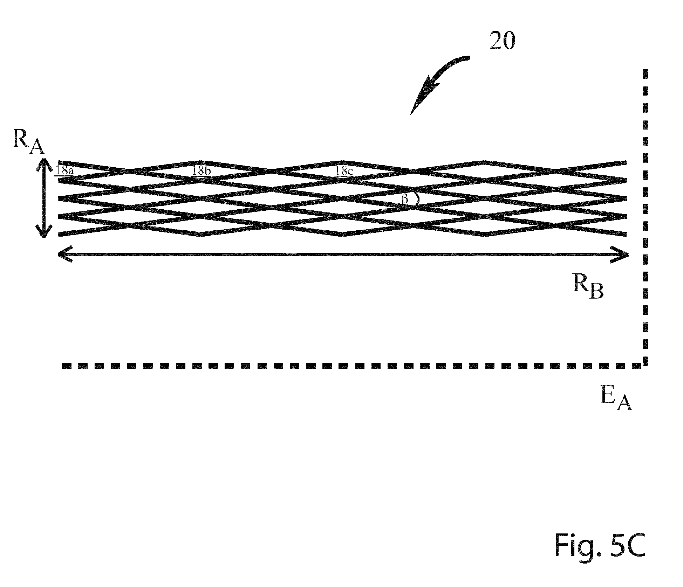

Fig. 5A zeigt zusammen mit Fig. 5B und Fig. 5C eine weitere Ausführungsform eines Solarkollektors. In diesen drei Abb. wird die Ausführungsform jeweils in schematischer Aufsicht aus Blickrichtung der Hauptachse H gezeigt. Die Ebene, auf die man blickt, also die Aufsichtsebene, wird als Ebene E_{A} bezeichnet. Diese Ebene E_{A} ist hier stets eine zu der oder den Hauptachsen senkrechte Ebene. Zur Orientierung sind wiederum drei Paneelverbände eingezeichnet, die Paneelverbände 18a, 18b und 18c.

Zwischen benachbarten Paneelen ist ein Öffnungswinkel β (Beta) vorgesehen, der repräsentativ für einen Paneelverband eingezeichnet ist.

Fig. 5B zeigt, dass der dargestellte Paneelverband in eine andere Stellung überführt werden kann. In dieser Stellung ist der Winkel β (Beta), der in Fig. 5A 90 Grad betrug, spitzer. Dementsprechend ist die Ausdehnung des Solarkollektors 20 in der Ebene E_{A} geringer. Seine Ausdehnung entlang einer ersten Ausdehnungsrichtung R_{A} hat sich stark verringert. Allerdings hat seine Ausdehnung entlang einer zweiten Ausdehnungsrichtung R_{B}, welche senkrecht zur Richtung R_{A} verläuft, sich leicht erhöht.

Fig. 5C zeigt denselben Solarkollektor 20 in einer weiteren Stellung. Der Winkel β Beta ist noch spitzer. Dementsprechend ist die Ausdehnung des Solarkollektors in der Richtung R_{A} stark reduziert. In Richtung R_{B} ist die Ausdehnung leicht erhöht. Insgesamt aber wird in der Ebene E_{A} eine deutlich verringerte Fläche eingenommen.

In der in Fig. 5C gezeigten Konfiguration nimmt der Solarkollektor also wenig Platz ein. Dementsprechend gibt er auch einfallendem Wind oder einfallendem Regen wenig Auftrefffläche. Andererseits sind die Solarpaneele zum guten Teil durch andere Solarpaneele abgedeckt, so dass sich wenig Einstrahlfläche für Sonnenlicht bietet. Man kann die in Fig. 5C gezeigte Stellung des Solarkollektors daher auch als Transportkonfiguration bezeichnen. Dementsprechend kann die in Fig. 5A gezeigte Stellung als Nutzkonfiguration bezeichnet werden.

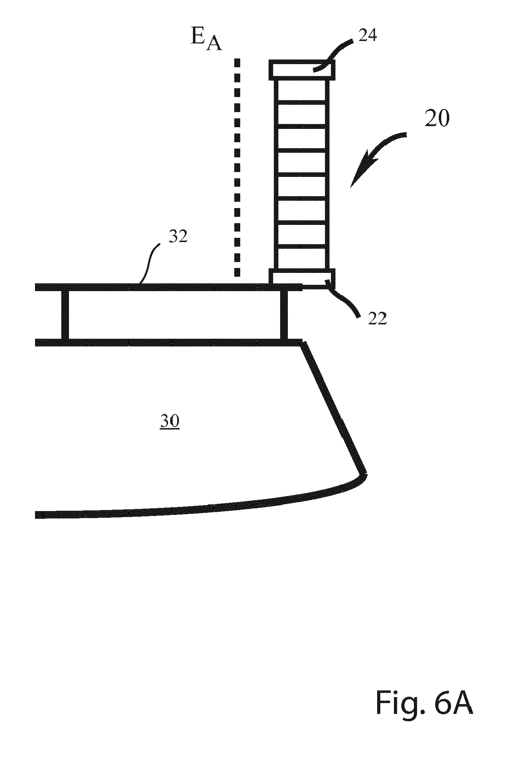

Fig. 6A zeigt den Einsatz eines Solarkollektors 20 an einem Boot 30. Die Darstellung ist wiederum schematisch. Der Solarkollektor 20 ist zwischen einer ersten Halterung 22 und einer zweiten Halterung 24 aufgespannt. Die erste Halterung 22 ist mit der Reling 32 des Bootes verbunden. In dieser Stellung kann gut Sonnenlicht eingefangen werden.

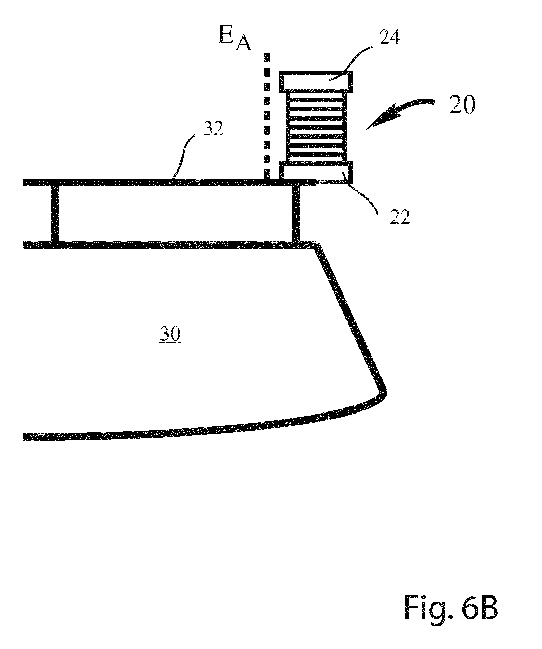

Fig. 6B zeigt, dass der Solarkollektor 20 von seiner Transportstellung in eine Nutzstellung überführt werden kann. Hierzu werden die erste Halterung und die zweite Halterung aufeinander zubewegt. Die Halterungen bewegen sich dabei in der Ebene E_{A}. In der gezeigten Transportstellung bietet der Solarkollektor einen deutlich geringeren Windwiderstand. Je nach Nutzung des Bootes und nach Wind- und Wetterverhältnissen kann dies sehr erstrebenswert sein.

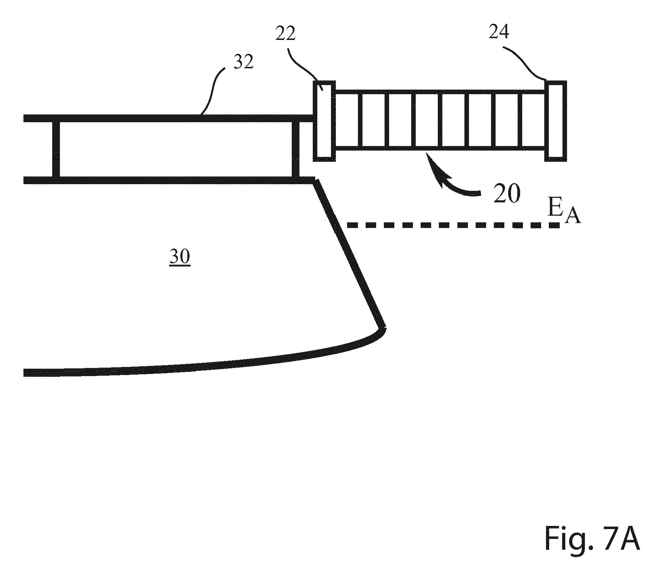

Fig. 7A zeigt den Solarkollektor wiederum in seiner Nutzkonfiguration. Er ist wiederum zwischen einem Halter 22 und einem zweiten Halter 24 aufgespannt. Mit dem ersten Halter 22 ist er an der Reling 32 eines Bootes 30 montiert. Die Ebene E_{A} erstreckt sich diesmal in der Waagerechten. Der Solarkollektor kann auch in dieser Ausrichtung sinnvoll an einem Boot montiert werden. Je nach Konstruktion der Halterung 22 kann es auch möglich sein, den Solarkollektor aus einer senkrechten in die waagerechte Orientierung zu überführen. Es kann ferner auch möglich sein, die Ebene E_{A} relativ zum Boot 30 frei einzustellen. Dabei kann insbesondere der Winkel der Ebene E_{A} zur senkrechten verstellt werden - frei oder in Stufen gewählt werden.

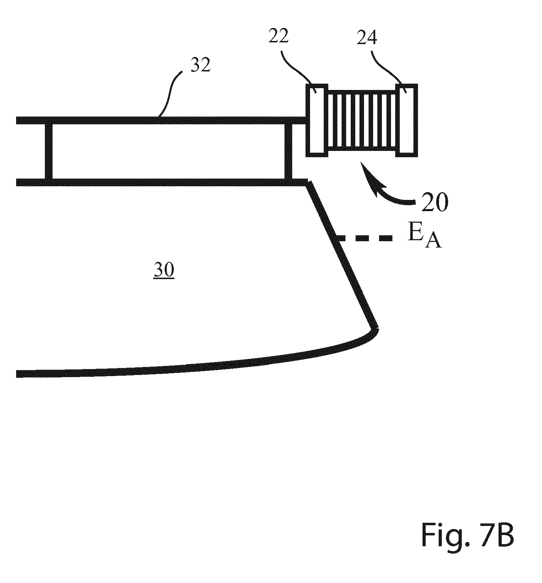

Fig. 7B zeigt, dass auch bei waagerechter Montage die Überführung von einer Nutzkonfiguration in eine Transportkonfiguration möglich ist. Dazu wird der zweite Halter 24 auf den ersten Halter 22 zubewegt.

Solarkollektoren können sehr vorteilhaft zur mobilen Stromversorgung eingesetzt werden. Besonders vorteilhaft ist ein solcher Einsatz auf nicht oder nicht ausschließlich motorbetriebenen Fahrzeugen. Dazu können pedalgetriebene Fahrzeuge, wie beispielsweise Fahrräder gehören, aber auch Boote. Wichtig kann eine dauerhafte Stromversorgung auf Segelbooten sein. Segelboote sind in der Regel allenfalls mit einem Hilfsmotor ausgerüstet, haben aber einen gewissen Stromverbrauch für Beleuchtungseinrichtungen, Navigationsgeräten, usw. Diesen Strom sicher zu erzeugen, stellt eine Herausforderung dar. Die Stromerzeugung mit Solarzellen ist dabei durchaus interessant. Zu bedenken ist allerdings, dass das Boot sich in einer fast zufälligen Lage zur Sonne befindet, und es nicht zweckmäßig erscheint, den Bootskurs auf den Sonnenstand auszurichten. Ebenfalls kommt es häufig aus Platzgründen nicht in Betracht, beispielsweise durch motorgetriebene Verstellung, die Solarzellen immer neu optimal zur Sonne auszurichten.

Solarpaneele nach der vorliegenden Erfindung, welche bei verschiedenen Sonnenständen gut arbeiten, sind daher besonders für einen solchen Einsatz auf einem Boot optimal. Da jedoch der Solarkollektor selbst auch einige Angriffsfläche für Wind bietet und er so schließlich sogar als ungewolltes Zusatzsegel wirken könnte, ist es sehr vorteilhaft, wenn der Solarkollektor in eine Transportstellung überführt werden kann, bei der er dem Wind und auch sonstigem Wetter wenig Angriffsfläche bietet.

Neben der Möglichkeit der Überführung von einer Transportkonfiguration in die Nutzkonfiguration und auch wegen der Möglichkeit, den Solarkollektor in verschiedenen Zwischenstellungen zu verwenden, ist die Verwendung eines solchen Solarkollektors als Art Jalousie oder Beschattungseinrichtung möglich. In dieser Weise könnten solche Solarkollektoren hinter Bordfenstern eingesetzt werden oder auch zur Abschattung von Deckbereichen verwendet werden. Eine entsprechende Verwendung ist auch außerhalb von Booten sowohl in generell waagerechter wie auch in generell senkrechter Orientierung gut möglich.

Insgesamt zeigt sich, wie ein sehr zweckmäßiger Solarkollektor gebaut werden kann, welcher bei verschiedenen Sonnenständen gut eingesetzt werden kann und zur Montage auf einem Schiff besonders zweckmäßig ist.

### Bezugszeichenliste

- 10: erstes Solarpaneel
- 12: zweites Solarpaneel
- 14: drittes Solarpaneel
- 16: viertes Solarpaneel
- 18: Paneelverband
- 20: Solarkollektor
- 22: erste Halterung
- 24: zweite Halterung
- 30: Boot
- 32: Reeling
- H: Hauptachse
- E₁: Erstreckungsebene von 10
- E₂: Ersteckungsebene von 12
- S₁: Senkrechte auf E₁
- S₂: Senkrechte auf E₂
- E_{A}: Aufsichtebene
- R_{A}: erste Erstreckungsrichtung in Aufsichtsebene
- R_{B}: zweite Erstreckungsrichtung in Aufsichtsebene
- α: Winkelbereich um H
- β: Paneelwinkel

## Patentansprüche

1. Solarkollektor (20), der eine Vielzahl von Solarpaneelen (10, 12, 14, 16) umfasst, welche sich im Wesentlichen in einer Paneelfläche erstrecken, wobei jedes Solarpaneel mindestens eine Solarzelle umfasst, wobei der Solarkollektor mindestens einen Paneelverband (18) umfasst, welcher mindestens ein erstes Solarpaneel (10) und mindestens ein zweites Solarpaneel (12) umfasst, wobei das erste Solarpaneel (10) eine erste Flächensenkrechte (S₁) auf der Paneelfläche (E₁) aufweist, und wobei das zweite Solarpaneel (12) eine zweite Flächensenkrechte (S₂) auf der Paneelfläche (E₂) aufweist, und wobei das erste Solarpaneel (10) und das zweite Solarpaneel (12) nicht in einer Ebene verlaufen, und der Paneelverband eine Hauptachse (H) aufweist, welche im Wesentlichen parallel zur Paneelfläche des ersten Solarpaneels (10) und zur Paneelfläche des zweiten Solarpaneels (12) verläuft, und welche den Kreuzungspunkt der ersten Flächensenkrechten (S₁) mit der zweiten Flächensenkrechten (S₂) schneidet, **dadurch gekennzeichnet, dass** die Hauptachse (H) kein Solarpaneel des Paneelverbandes schneidet, und Solarpaneele in einem Winkelbereich von mindestens 180 Grad um die Hauptachse (H) angeordnet sind.

2. Solarkollektor (20) nach Anspruch 1, bei dem Solarpaneele in einem Winkelbereich von mehr als 270 Grad um die Hauptachse (H) angeordnet sind.

3. Solarkollektor (20) nach einem der vorhergehenden Ansprüche, bei dem Solarpaneele in einem Winkelbereich von 360 Grad um die Hauptachse (H) angeordnet sind.

4. Solarkollektor (20) nach einem der vorhergehenden Ansprüche, bei dem der Einfall von Sonnenlicht aus Richtungen in einem Winkelbereich von 10 Grad bis 80 Grad zur Hauptachse (H) möglich ist.

5. Solarkollektor (20) nach einem der vorhergehenden Ansprüche, bei dem mindestens ein Paneelverband 3 bis 5 Solarpaneele, vorzugsweise 4 Solarpaneele aufweist.

6. Solarkollektor (20) nach dem vorhergehenden Anspruch, bei dem die Solarpaneele aus Blickrichtung der Hauptachse (H) einen quadratischen oder rautenförmigen Querschnitt beschreiben.

7. Solarkollektor (20) nach einem der vorhergehenden Ansprüche, bei dem die Solarpaneele runde oder rechteckige Solarzellen aufweisen.

8. Solarkollektor (20) nach einem der vorhergehenden Ansprüche, bei dem der Winkel zwischen dem ersten Solarpaneel (10) und dem zweiten Solarpaneel (12) veränderlich ist.

9. Solarkollektor (20) mit einer Vielzahl von Paneelverbänden (18), welcher sich in einer zur Hauptachse (H) senkrechten Ebene (E_{A}) erstreckt, und dort eine Fläche von veränderlicher Größe abdeckt.

10. Solarkollektor (20) nach einem der vorhergehenden Ansprüche, welcher von einem ersten Halter (22) und einem zweiten Halter (24) gehalten wird.

11. Solarkollektor (20) nach dem vorhergehenden Anspruch, bei dem der erste Halter und der zweite Halter parallel in der Ebene (E_{A}) aufeinander zu und voneinander wegbewegt werden können.

12. Solarkollektor (20) zur Montage auf einem Schiff, wobei sich die Ebene (E_{A}) waagerecht erstreckt.

13. Solarkollektor (20), vorzugsweise zur Montage auf einem Schiff, wobei sich die Ebene (E_{A}) senkrecht erstreckt.

14. Schifif, vorzugsweise Segelschifif, mit einem Solarkollektor (20) nach einem der vorhergehenden Ansprüche.
